# EUROPEAN PATENT APPLICATION

(11) **EP 2 530 749 A1**
(43) Date of publication of application: **05.12.2012**
(21) Application number: 10844699.8
(22) Date of filing: 07.12.2010
(51) Int. Cl.: H01L 33/48, H01L 33/60

(54) **SUBSTRATE FOR MOUNTING LIGHT EMITTING ELEMENT, METHOD FOR PRODUCING SAME, AND LIGHT EMITTING DEVICE**

(30) Priority: 28.01.2010 JP 2010017225
(71) Applicant: Asahi Glass Company, Limited, Chiyoda-ku Tokyo 100-8405 (JP)
(72) Inventor: NAKAYAMA, Katsuyoshi, Tokyo 1008405 (JP)
(74) Representative: Müller-Boré & Partner Patentanwälte
(86) International application number: PCT/JP2010/071928
(87) International publication number: WO 2011/092945

(57) **Abstract**

To provide a substrate for mounting a light-emitting element with a reduced gap provided to achieve insulation between a metal reflection film and an electrical wiring conductor portion formed on a LTCC substrate for mounting a light-emitting element, its production process and a light-emitting device.

A substrate for mounting a light-emitting element, which comprises a substrate main body made of a sintered product of a glass ceramic composition containing a glass powder and a ceramic filler, a part thereof constituting a mounting surface to be a mounting portion on which a light-emitting element is to be mounted; electrical wiring conductors to be electrically connected to an electrode of the light-emitting element, arranged at a stepped portion differing in the height from the mounting surface provided on the mounting surface of the substrate main body; a reflection film formed on the mounting surface excluding the stepped portion and the vicinity of its periphery; and an overcoat glass film provided on the mounting surface so as to cover the entire reflection film including its edge and so as to exclude the stepped portion and the vicinity of its periphery.

## Description

### TECHNICAL FIELD

The present invention relates to a substrate for mounting a light-emitting element, its production process and a light-emitting device.

### BACKGROUND ART

In recent years, along with a tendency to high brightness and whitening of a light-emitting diode element (chip), a light-emitting device employing a light-emitting diode element has been used for e.g. backlights of cellular phones or large-sized liquid crystal TVs. However, as the heat value is increased along with the tendency to high brightness of a light-emitting diode element and its temperature is excessively increased, a sufficient light-emitting brightness is not necessarily obtained. Accordingly, as a substrate for a light-emitting element to mount a light-emitting element such as a light-emitting diode element, a substrate from which heat generated from the light-emitting element is quickly dissipated and with which a sufficient light-emitting brightness can be obtained, is desired.

Heretofore, as a substrate for mounting a light-emitting element, for example, an alumina substrate has been used. Further, as the thermal conductivity of an alumina substrate is at a level of from 15 to 20 W/m·K and is not necessary high, use of an aluminum nitride substrate having a higher thermal conductivity has also been studied.

However, the material cost of the aluminum nitride substrate is high, and the process cost tends to be high as it is hardly sintered and thus high temperature firing is necessary. Further, the coefficient of thermal expansion of the aluminum nitride substrate is so low as from 4×10⁻⁶ to 5×10⁻⁶/°C, and if such an aluminum nitride substrate is mounted on a general-purpose printed board having a coefficient of thermal expansion of at least 9×10⁻⁶/°C, a sufficient connection reliability is not necessarily obtained due to the difference in the thermal expansion.

To overcome such problems, use of a low temperature co-fired ceramic substrate (hereinafter referred to as a LTCC substrate) as the substrate for mounting a light-emitting element has been studied. The LTCC substrate comprises, for example, glass and an alumina filler. As their refractive index difference is significant, their interface is large, and as the thickness of the substrate is thicker than the wavelength to be utilized, a high reflectance can be obtained, whereby light from the light-emitting element can efficiently be utilized and as a result, the heat value can be reduced. Further, as it is made of an inorganic oxide which is less likely to be deteriorated by light, it can maintain a stable color tone over a long period.

One of characteristics of the LTCC substrate as the substrate for mounting a light-emitting element is having a high reflectance as mentioned above. Further, for the purpose of reflecting light emitted from the light-emitting element forward as far as possible, an attempt to apply a silver reflection film on the surface of the LTCC substrate and forming an overcoat glass on the surface of the silver reflection film to prevent oxidation or sulfurization, has been made. Here, in a case where a silver reflection film is provided on the LTCC substrate for mounting a light-emitting element, the larger its area, the higher the light extraction efficiency, however, it will be necessary to provide a gap to secure insulation as a pair of electrical wiring conductors are provided on the same plane.

However, such a problem arises that from the gap formed for insulation, light enters into the LTCC substrate and the most of the entered light is diffusely reflected in the substrate and reradiation is difficult, and accordingly the presence of the gap leads to a decrease in the reflectance of the substrate. Accordingly, for the LTCC substrate for mounting a light-emitting element, development of a technique to make the area of the gap as small as possible so as to improve the light extraction efficiency of the light-emitting element.

As a technique to overcome the decrease in the reflection efficiency by the insulation portion in the substrate for mounting a light-emitting element, for example, improvement in the structure of the LTCC substrate as disclosed in Patent Documents 1 and 2 has been known. Patent Document 1 discloses an invention regarding a substrate for mounting a light-emitting element having such a constitution that a light reflection layer made of a metal and an insulating layer to cover the light reflection layer are formed, and electrical wiring conductors are provided on the insulation layer, so as to reduce the gap between the electrical wiring conductors on the substrate for mounting a light-emitting element. Further, Patent Document 2 discloses an invention regarding a substrate for mounting a light-emitting element having such a constitution that on an aluminum nitride substrate, a conductor wiring pattern and an insulating layer made of an aluminum nitride paste differing in the sintering temperature from an aluminum nitride composition constituting the substrate, are provided, to prevent light from entering into the substrate through gaps in the conductor wiring pattern on the aluminum nitride substrate. However, an attempt to reduce the gap between the reflection film and the electrical wiring conductor in a LTCC substrate comprising a reflection film and electrical wiring conductors on the substrate as mentioned above has not been known yet.

### PRIOR ART DOCUMENTS

### PATENT DOCUMENTS

Patent Document 1: JP-A-2006-100444
Patent Document 2: JP-A-2008-34513

### DISCLOSURE OF INVENTION

### TECHNICAL PROBLEM

The present invention has been made to overcome the above problems and its object is to provide a substrate for mounting a light-emitting element with a reduced gap provided to achieve insulation between a metal reflection film and an electrical wiring conductor portion formed on a LTCC substrate for mounting a light-emitting element, and its production process.

### SOLUTION TO PROBLEM

The substrate for mounting a light-emitting element of the present invention comprises a substrate main body made of a sintered product of a glass ceramic composition containing a glass powder and a ceramic filler, a part thereof constituting a mounting surface to be a mounting portion on which a light-emitting element is to be mounted; electrical wiring conductors to be electrically connected to an electrode of the light-emitting element, arranged at a stepped portion differing in the height from the mounting surface provided on the mounting surface of the substrate main body; a reflection film formed on the mounting surface excluding the stepped portion and the vicinity of its periphery; and an overcoat glass film provided on the mounting surface so as to cover the entire reflection film including its edge and so as to exclude the stepped portion and the vicinity of its periphery.

As the material constituting the reflection film, in addition to silver, a metal powder comprising silver and palladium, or a metal powder comprising silver and platinum may be used. Among them, in the present invention, a reflection film substantially comprising silver having a high reflectance is preferred. Here, a reflection film substantially comprising silver means that in a case where the reflection film is formed by a silver paste, components to form the paste, contained in the silver paste, may remain in the formed reflection film, or that other components to improve durability of silver may be contained. A reflection film substantially comprising silver means a reflection film containing at least 90 mass% of silver, and a silver alloy is included. For example, palladium may be contained up to 10 mass%, and platinum may be contained up to 3 mass%.

In the substrate for mounting a light-emitting element of the present invention, the stepped portion provided on the mounting surface preferably forms a concave.

In the substrate for mounting a light-emitting element of the present invention, on the substrate mounting surface in the vicinity of the periphery of the stepped portion, a portion where no covering layer by the reflection film and the overcoat glass film is formed, i.e. a non-coated portion is formed. The width of the non-coated portion is preferably from 20 to 80 µm. The width of the non-coated portion may not necessarily be within a range of from 20 to 80 µm in the entire portion, and it is preferred that most of the portion has a width within such a range. That is, such a non-coated portion that a part of the perimeter of the periphery of the stepped portion has an extremely broad or narrow width, is included. However, the width of the non-coated portion is preferably at most 110 µm at the broadest portion and at least 10 µm at the narrowest portion.

In the substrate for mounting a light-emitting element of the present invention, the difference in the height between the mounting surface and the stepped portion is preferably from 50 to 200 µm.

Further, the present invention provides a process for producing the above substrate for mounting a light-emitting element of the present invention, which comprises forming such a constitution that the substrate main body has the stepped portion differing in the height from the mounting surface on the mounting surface, by laminating a plurality of green sheets differing in the shape, made of a glass ceramic composition containing a glass powder and a ceramic filler, and forming the electrical wiring conductors, the reflection film and the overcoat glass film by screen printing.

Regarding the production process of the present invention, as a production process in a case where the stepped portion provided on the mounting surface of the substrate main body forms a concave, a process for producing the substrate for mounting a light-emitting element comprising the following steps (A) to (D) (hereinafter referred to as "a production process according to a first embodiment" of the present invention) is provided.
(A) a step of preparing a green sheet for main body constituting mainly the substrate main body of the substrate for mounting a light-emitting element by using a glass ceramic composition containing a glass powder and a ceramic filler, and arranging an electrical wiring conductor paste layer by screen printing on predetermined positions on the main surface of the green sheet for main body to obtain a main body forming member;
(B) a step of preparing a green sheet for covering constituting the mounting surface of the substrate for mounting a light-emitting element, made of the above glass ceramic composition and having through holes penetrating in a thickness direction at portions corresponding to the electrical wiring conductors of the substrate for mounting a light-emitting element, and laminating the green sheet for covering on the main surface of the main body forming member so as to face the electrical wiring conductor paste layer through the through holes to obtain a green sheet laminate;
(C) a step of forming a paste layer for reflection film by screen printing on the surface of the green sheet for covering of the green sheet laminate so as to exclude the through holes and the vicinity of their periphery, and further forming an overcoat glass paste layer by screen printing so as to cover the entire paste layer for reflection film including its edge and so as to exclude the through holes and the vicinity of their periphery to obtain a non-sintered substrate for mounting a light-emitting element; and
(D) a step of firing the non-sintered substrate for mounting a light-emitting element at from 800 to 930°C.

Further, as a production process according to another embodiment of the present invention in a case where the stepped portion provided on the mounting surface of the substrate main body forms a concave, a process for producing the substrate for mounting a light-emitting element comprising the following steps (A), (B)', (C)' and (D) (hereinafter referred to as "a production process according to a second embodiment" of the present invention) is provided.
(A) a step of preparing a green sheet for main body constituting mainly the substrate main body of the substrate for mounting a light-emitting element by using a glass ceramic composition containing a glass powder and a ceramic filler, and arranging an electrical wiring conductor paste layer by screen printing on predetermined positions on the main surface of the green sheet for main body to obtain a main body forming member;
(B)' a step of preparing a green sheet for covering constituting the mounting surface of the substrate for mounting a light-emitting element, made of the above glass ceramic composition and having through holes penetrating in a thickness direction at portions corresponding to the electrical wiring conductors of the substrate for mounting a light-emitting element, forming a paste layer for reflection film by screen printing on the surface to be the mounting surface of the obtained green sheet for covering so as to exclude the through holes and the vicinity of their periphery, and further forming an overcoat glass paste layer by screen printing so as to cover the entire paste layer for reflection film including its edge and so as to exclude the through holes and the vicinity of their periphery, to obtain a member for covering;
(C)' a step of laminating the member for covering on the main surface of the main body forming member so as to face the electrical wiring conductor paste layer through the through holes and so that the overcoat glass paste layer faces upward, to obtain a non-sintered substrate for mounting a light-emitting element; and
(D) a step of firing the non-sintered substrate for mounting a light-emitting element at from 800 to 930°C.

The light-emitting device of the present invention comprises the above substrate for mounting a light-emitting element of the present invention, and a light-emitting element mounted on the mounting portion of the substrate for mounting a light-emitting element.

In the light-emitting device of the present invention, it is preferred that each of a pair of electrodes which each electrical wiring conductor arranged at the stepped portion provided on the mounting surface of the substrate for mounting a light-emitting element of the present invention has and which the light-emitting element mounted on the mounting portion of the substrate for mounting a light-emitting element has, and each electrical wiring conductor, are connected in one-on-one by wire bonding.

### ADVANTAGEOUS EFFECTS OF INVENTION

According to the present invention, it is possible to provide a substrate for mounting a light-emitting element which has a small area of a gap provided to achieve insulation between a metal reflection film and an electrical wiring conductor portion formed on the substrate, and which is excellent in the light extraction efficiency when a light-emitting element is mounted to form a light-emitting device.

### BRIEF DESCRIPTION OF DRAWINGS

Fig. 1 is a plan view as viewed from above illustrating one embodiment of a substrate for mounting a light-emitting element of the present invention.
Fig. 2 is a cross-sectional view illustrating a part corresponding to the line X-X' in Fig. 1 of the embodiment of a substrate for mounting a light-emitting element as shown in Fig. 1.
Fig. 3 is a cross-sectional view illustrating one example of a light-emitting device using the substrate for mounting a light-emitting element of the present invention.
Fig. 4 is views schematically illustrating one embodiment of a process for producing the substrate for mounting a light-emitting element of the present invention according to a first embodiment.
Fig. 5 is views schematically illustrating one embodiment of a process for producing the substrate for mounting a light-emitting element of the present invention according to a second embodiment.
Fig. 6 is a view illustrating a cross-section of a light-emitting device having a conventional substrate for mounting a light-emitting element used for comparison in Examples.

### DESCRIPTION OF EMBODIMENTS

Now, the embodiment of the present invention will be described with reference to drawings.

The substrate for mounting a light-emitting element of the present invention comprises a substrate main body made of a sintered product of a glass ceramic composition containing a glass powder and a ceramic filler, a part thereof constituting a mounting surface to be a mounting portion on which a light-emitting element is to be mounted; electrical wiring conductors to be electrically connected to an electrode of the light-emitting element, arranged at a stepped portion differing in the height from the mounting surface provided on the mounting surface of the substrate main body; a reflection film formed on the mounting surface excluding the stepped portion and the vicinity of its periphery; and an overcoat glass film provided on the mounting surface so as to cover the entire reflection film including its edge and so as to exclude the stepped portion and the vicinity of its periphery.

According to the present invention, by forming a step (a difference in the height) between the light-emitting element mounting surface on which the reflection film is provided of the substrate main body and the surface on which electrical wiring conductors to be electrically connected to an electrode of the light-emitting element are arranged, the gap area between the reflection film and the electrical wiring conductors can be made small. Accordingly, when a light-emitting device having a light-emitting element mounted on such a substrate for mounting a light-emitting element is used, entrance of light emitted from the light-emitting element through gaps into the substrate can be reduced, and a light-emitting device with a high light extraction efficiency can be achieved.

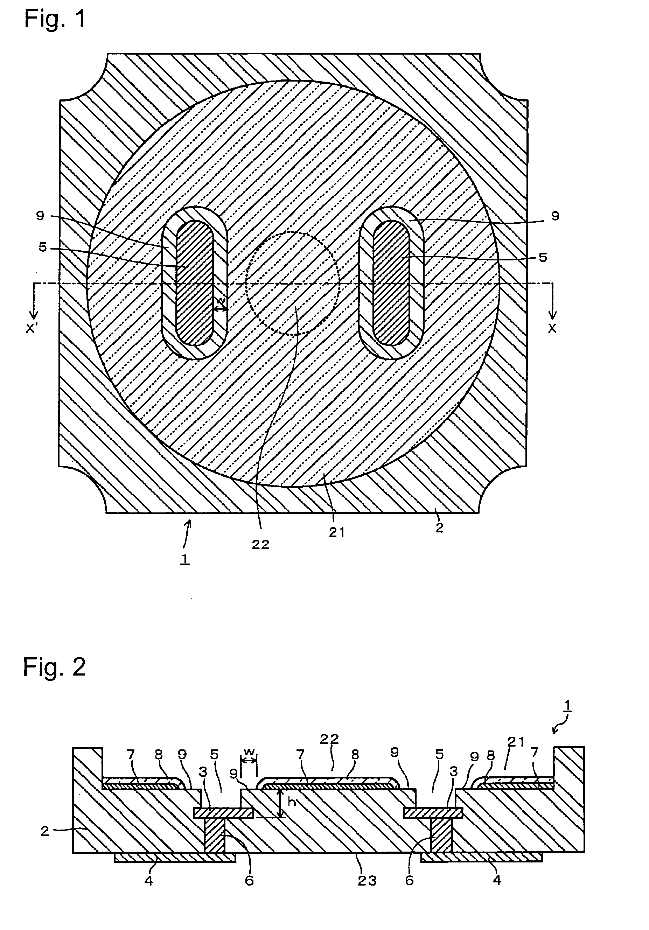

Fig. 1 is a plan view as observed from above illustrating one embodiment of a substrate for mounting a light-emitting element of the present invention, and Fig. 2 is a cross-sectional view illustrating a portion corresponding to the line X-X' in Fig. 1 of the embodiment of a substrate for mounting a light-emitting element as shown in Fig. 1.

A substrate 1 for mounting a light-emitting element has a substrate main body 2 having a substantial plate form mainly constituting the substrate 1 for mounting a light-emitting element. The substrate main body 2 is made of a sintered product of a glass ceramic composition containing a glass powder and a ceramic filler, one surface (the upper side in Fig. 2) forms a mounting surface 21 on which a light-emitting element is to be mounted, and its substantially center portion forms a mounting portion 22 on which a light-emitting element is to be practically mounted. Further, the other surface forms a non-mounting surface 23 on which a light-emitting element is not mounted. The substrate main body 2 preferably has, for example, a flexural strength of at least 250 MPa with a view to suppressing e.g. breakage at the time of mounting a light-emitting element or at the time of use after mounting.

The shape, the thickness, the size, etc. of the substrate main body are not particularly limited and are the same as those of conventional one used as a substrate for mounting a light-emitting element. Further, the material composition, the sintering conditions, etc. of the sintered product of the glass ceramic composition containing a glass powder and a ceramic filler constituting the substrate main body 2 will be described in the after-mentioned process for producing the substrate for mounting a light-emitting element.

The substrate main body 2 has concaves 5 on parts of the mounting surface 21, and at the bottom of each concave 5, an electrical wiring conductor 3 to be electrically connected to a light-emitting element is provided. On the non-mounting surface 23, external electrode terminals 4 to be electrically connected to an external circuit are provided, and in the interior of the substrate main body 2, through hole conductors 6 to electrically connect the electrical wiring conductors 3 and the external electrode terminals 4 are provided.

Each electrical wiring conductor 3 is arranged over the entire bottom surface of each concave 5 so as not to form a non-coated portion on the substrate main body. The constitution of the electrical wiring conductors is not particularly limited so long as it is the same as that of an electrical wiring conductor to be used for a conventional substrate for mounting a light-emitting element, however, a preferred thickness is from 5 to 15 µm. The constituting material will be described in the after-mentioned production process. The shape and the constituting material of the external electrode terminals 4 and through hole conductors 6 are not particularly limited so long as they are the same as those to be employed for a conventional substrate for mounting a light-emitting element. Further, disposition of the external electrode terminals 4 and the through hole conductors 6 is also not particularly limited so long as electrical connection from the electrical wiring conductors 3 to an external electrode (not shown) is achieved.

In this embodiment, concaves 5 are formed on the mounting surface 21 as each stepped portion differing in the height from the mounting surface 21 at which the electrical wiring conductor 3 is arranged, however, convexes may be provided instead of the concaves, and an electrical wiring conductor may be arranged at the highest portion of each convex. The shape of the stepped portion is preferably such that the side wall is vertical to the mounting surface in both cases of concaves and convexes, and the lowest portion (bottom) in the case of the concaves or the highest portion in the case of the convexes is horizontal to the mounting surface. The shape of the stepped portion is preferably concaves considering easiness of production.

Further, the position, the size, the shape, etc. of the stepped portions when the substrate for mounting a light-emitting element is observed from above are the same as the position, the size, the shape, etc. of electrical wiring conductors required in a conventional substrate for mounting a light-emitting element. Further, in this embodiment, the number of the concaves which the substrate main body has on the mounting surface side is 2, but the number may properly be adjusted depending on the number of electrical wiring conductors required for the substrate for mounting a light-emitting element.

Here, the distance between the surface on which the electrical wiring conductor is arranged in the stepped portion and the mounting surface of the substrate main body, i.e. the difference in the height (for example, represented by h in Fig. 2), is preferably from 50 to 200 µm, more preferably from 100 to 150 µm. If this difference in the height is less than 50 µm, the distance between the electrical wiring conductor and the reflection film may not sufficiently be secured, and if it exceeds 200 µm, entrance of light from the side wall surfaces at the concave tends to be significant, and the light extraction efficiency may be decreased in some cases.

In the substrate 1 for mounting a light-emitting element, a reflection film 7 is formed on the surface excluding the concaves 5 and the vicinity of their periphery on the mounting surface 21, and an overcoat glass film 8 is provided on the reflection film 7 so as to cover the entire reflection film 7 including its edge and so as to exclude the concaves 5 and the vicinity of their periphery. According to this embodiment, by the concaves 5 formed on the mounting surface 21 and the electrical wiring conductor 3 provided at the bottom of each concave 5, the area of a non-coated portion 9 where the reflection film 7 and the overcoat glass film 8 are not formed on the mounting surface 21 of the substrate main body can be made small.

The thickness of the reflection film 7 depends on the design of a light-emitting device for which the substrate for mounting a light-emitting element is to be used, and it is preferably at least 5 µm to obtain sufficient reflection performance, and is preferably at most 50 µm considering the economical efficiency, the deformation due to the difference in the thermal expansion from the substrate, etc. Further, the thickness of the overcoat glass film 8 also depends on the design of a light-emitting device for which the substrate for mounting a light-emitting element is to be used, and is preferably from 10 to 50 µm considering the thermal conductivity, the deformation due to the difference in the thermal expansion from the substrate, etc. The material composition regarding the reflection film and the overcoat glass film will be described in the after-mentioned production process.

The width of the non-coated portion 9 represented by "w" in Figs. 1 and 2 is preferably from 20 to 80 µm, more preferably from 30 to 50 µm. If the width of the non-coated portion 9 exceeds 80 µm, the amount of entrance of light emitted from a light-emitting element into the substrate tends to increase and as a result, the light extraction efficiency may be decreased in some cases. Further, if it is less than 20 µm, there may be drawbacks in view of production.

Further, the distance between the edge of the reflection layer 7 and the edge of the overcoat glass film 8 covering the reflection layer 7 is preferably as short as possible within a range where the reflection layer is sufficiently protected from the external deteriorating factors. Specifically, it is preferably from 10 to 50 µm, more preferably from 20 to 30 µm. If this distance is less than 10 µm, due to exposure of the reflection layer, oxidation, sulfurization or the like of the material constituting the reflection layer may occur, whereby the reflectance may be decreased, and if it exceeds 50 µm, the region where the substrate main body is covered only with the overcoat glass film 8 tends to be increased, whereby the reflectance may be decreased.

Further, although not shown, thermal vias may be embedded in the interior of the substrate main body 2 to reduce the thermal resistance. A thermal via is a column small than the mounting portion 22 for example, and a plurality of thermal vias are provided directly below the mounting portion 22. In a case where thermal vias are provided, they are preferably provided over from the non-mounting surface 23 to the vicinity of the mounting surface 21 so that they do not reach the mounting surface 21. By such a disposition, flatness of the mounting surface 21 particularly the mounting portion 22 can be improved, the thermal resistance can be reduced, and the inclination when a light-emitting element is mounted can be suppressed.

The embodiment of the substrate for mounting a light-emitting element of the present invention is described with reference to one example, however, the substrate for mounting a light-emitting element of the present invention is not limited thereto. Various changes and modifications are possible without departing from the intention and the scope of the present invention, and as the case requires.

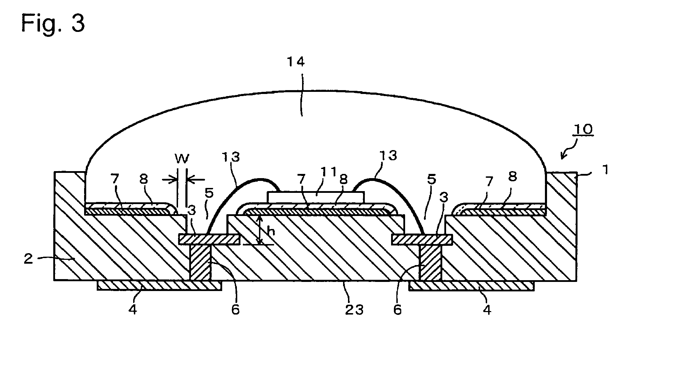

By using the substrate for mounting a light-emitting element of the present invention, a light-emitting device is mounted on the mounting portion, whereby a light-emitting device, for example, a light-emitting device shown in Fig. 3 is prepared.

A light-emitting device 10 shown in Fig. 3 has a light-emitting element 11 such as a light-emitting diode element mounted on the mounting portion 22 of the substrate 1 for mounting a light-emitting element. The light-emitting element 11 is fixed to the mounting portion 22 by means of an adhesive, and its electrode which is not shown in Fig. 3 is electrically connected to each electrical wiring conductor 3 by a bonding wire 13. Further, a mold material 14 is provided to cover the light-emitting element 11 and the bonding wires 13 to constitute the light-emitting device 10.

By the light-emitting device 10 employing the substrate for mounting a light-emitting element of the present invention, as the area of the gap between the electrical wiring conductor 3 and the reflection film 7 of the substrate 1 for mounting a light-emitting element is small, entrance of light emitted from the light-emitting element 11 into the substrate main body can be suppressed, the light extraction efficiency can be made high, and light can be emitted with a high brightness. Such a light-emitting device 10 can suitably be sued, for example, as backlights of cellular phones or large-sized liquid crystal displays, illumination for automobiles or for decoration, or other light sources.

The substrate for mounting a light-emitting element of the present invention may be produced as follows.

In the following description, members to be used for its production, layers to be formed, etc. will be described with reference to the same symbols as those of member of a complete product.

The substrate for mounting a light-emitting element of the present invention having a constitution such that the substrate main body has a stepped portion differing in the height from the mounting surface on the mounting surface is prepared, for example, by laminating a plurality of green sheets differing in the shape prepared by using a glass ceramic composition containing a glass powder and a ceramic filler. Further, formation of the electrical wiring conductors, the reflection film and the overcoat glass film can be carried out by screen printing. In the following, a simply described wording "green sheet" means a green sheet made of a glass ceramic composition containing a glass powder and a ceramic filler.

In a case where the stepped portion of the substrate for mounting a light-emitting element of the present invention forms a concave, the substrate for mounting a light-emitting element of the present invention is prepared, for example, in such a manner that on a green sheet having an electrical wiring conductor paste layer formed by screen printing on predetermined positions, a green sheet for covering having through holes at portions corresponding to the electrical wiring conductor paste layer is laminated, and on this green sheet for covering, a paste layer for reflection film and an overcoat glass paste layer are formed by screen printing excluding the through holes and their periphery, to prepare a non-fired substrate for mounting a light-emitting element, followed by firing.

Further, in a case where the stepped portion of the substrate for mounting a light-emitting element of the present invention forms a convex, the substrate for mounting a light-emitting element of the present invention is prepared in such a manner that a green sheet small piece having an electrical wiring conductor paste layer formed on its surface is laminated on portions at which an electrical wiring conductor is to be formed on a green sheet for forming the substrate main body, and a paste layer for reflection film and an overcoat glass paste layer are formed by screen printing excluding the laminated portions and their periphery, to prepare a non-fired substrate for mounting a light-emitting element, followed by firing.

Regarding the production process of the present invention, as a production process in a case where the stepped portion provided on the mounting surface of the substrate main body forms a concave, the above-mentioned production process according to a first embodiment and production process according to a second embodiment will be described below.

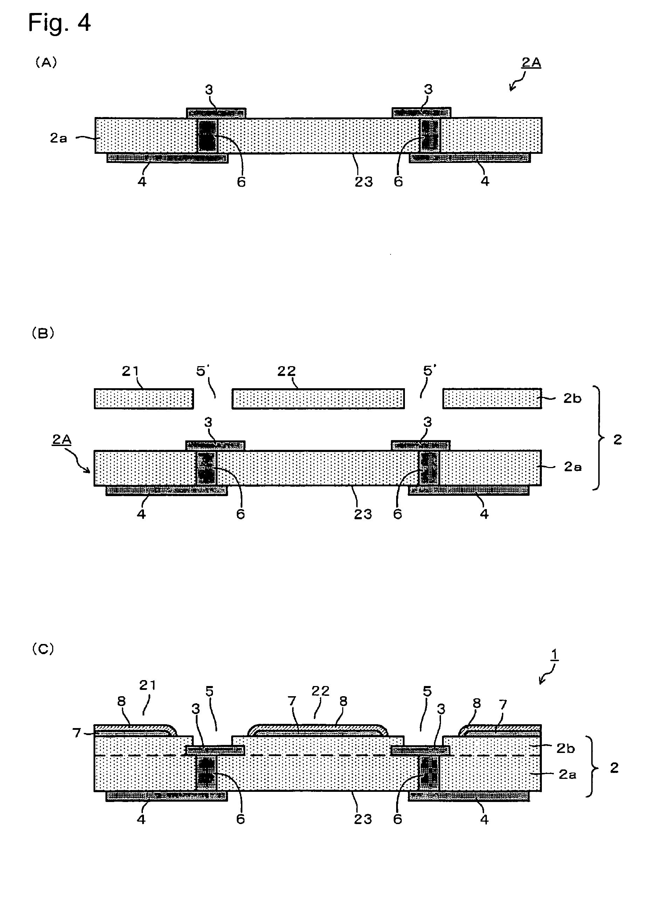

The production process according to a first embodiment of the present invention is specifically a process for producing the substrate for mounting a light-emitting element comprising the following steps (A) to (D), and one example of this embodiment is described with reference to Fig. 4. More specifically, it is preferred to produce the substrate for mounting a light-emitting element of the present invention by carrying out the following respective steps (A) to (D) in this order.
(A) A step of preparing a green sheet for main body constituting mainly the substrate main body of the substrate for mounting a light-emitting element by using a glass ceramic composition containing a glass powder and a ceramic filler, and arranging an electrical wiring conductor paste layer by screen printing on predetermined positions on the main surface of the green sheet for main body to obtain a main body forming member (hereinafter referred to as "a main body forming member preparation step").
(B) A step of preparing a green sheet for covering constituting the mounting surface of the substrate for mounting a light-emitting element, made of the above glass ceramic composition and having through holes penetrating in a thickness direction at portions corresponding to the electrical wiring conductors of the substrate for mounting a light-emitting element, and laminating the green sheet for covering on the main surface of the main body forming member so as to face the electrical wiring conductor paste layer through the through holes to obtain a green sheet laminate (hereinafter referred to as "a green sheet laminate preparation step").
(C) A step of forming a paste layer for reflection film by screen printing on the surface of the green sheet for covering of the green sheet laminate so as to exclude the through holes and the vicinity of their periphery, and further forming an overcoat glass paste layer by screen printing so as to cover the entire paste layer for reflection film including its edge and so as to exclude the through holes and the vicinity of their periphery to obtain a non-sintered substrate for mounting a light-emitting element (hereinafter referred to as "a step of forming a paste layer for reflection film, etc.").
(D) A step of firing the non-sintered substrate for mounting a light-emitting element at from 800 to 930°C (hereinafter referred to as "a firing step").

Now, the respective steps (A) to (D) will be described in detail with reference to the drawing.

### (A) Main body forming member preparation step

Fig. 4(A) is a view illustrating a cross-section of a main body forming member 2A obtained by a step including the above step (A). The main body forming member 2A has a constitution such that in the step (A), an electrical wiring conductor paste layer 3 is formed on the main surface of a green sheet 2a for main body, and on the other surface to be finally a non-mounting surface 23 of the substrate for mounting a light-emitting element, a conductor paste layer 4 for external electrode terminal, and a paste layer 6 for through hole conductor to electrically connect the electrical wiring conductor paste layer 3 and the conductor paste layer 4 for external electrode terminal, are formed.

The green sheet 2a for main body is produced by adding a binder and as the case requires, a plasticizer, a dispersing agent, a solvent, etc. to a glass ceramic composition containing a glass powder (a glass powder for substrate main body) and a ceramic filler to prepare a slurry, and forming the slurry into a sheet-form e.g. by a doctor blade method, followed by drying.

The glass powder for substrate main body is not particularly limited, but is preferably one having a glass transition point (Tg) of at least 550°C and at most 700°C. If the glass transition point (Tg) is less than 550°C, binder burn out may be difficult, and if it exceeds 700°C, the shrinkage starting temperature tends to be high, whereby the dimension accuracy may be decreased.

Further, preferred is one such that when fired at a temperature of at least 800°C and at most 930°C, crystals are deposited. In the case of one such that crystals are not deposited, no sufficient mechanical strength may be obtained. Further, preferred is one having a crystallization peak temperature (Tc) of at most 880°C as measured by DTA (differential thermal analysis). If the crystallization peak temperature (Tc) exceeds 880°C, the dimensional accuracy may be decreased.

Such a glass powder for substrate main body preferably has a glass composition comprising, as represented by mol% as calculated as the following oxides, for example, at least 57 mol% and at most 65 mol% of SiO₂, at least 13 mol% and at most 18 mol% of B₂O₃, at least 9 mol% and at most 23 mol% of CaO and at least 3 mol% and at most 8 mol% of Al₂O₃, containing at least one selected from K₂O and Na₂O, and comprising at least 0.5 mol% and at most 6 mol% of K₂O, Na₂O, or K₂O and Na₂O. By using a glass powder having such a composition, flatness of the surface of the substrate main body can easily be improved.

Here, SiO₂ is a component to be a glass network former. If the SiO₂ content is less than 57 mol%, stable glass will hardly be obtained, and chemical durability may also be decreased. On the other hand, if the SiO₂ content exceeds 65 mol%, the glass melting temperature or the glass transition point (Tg) may excessively be high. The SiO₂ content is preferably at least 58 mol%, more preferably at least 59 mol%, particularly preferably at least 60 mol%. Further, the SiO₂ content is preferably at most 64 mol%, more preferably at most 63 mol%.

B₂O₃ is a component to be a glass network former. If the B₂O₃ content is less than 13 mol%, the glass melting temperature or the glass transition point (Tg) may excessively be high. On the other hand, if the B₂O₃ content exceeds 18 mol%, stable glass will hardly be obtained, and the chemical durability may also be decreased. The B₂O₃ content is preferably at least 14 mol%, more preferably at least 15 mol%. Further, the B₂O₃ content is preferably at most 17 mol%, more preferably at most 16 mol%.

Al₂O₃ is added to increase the stability, the chemical durability and the strength of glass. If the Al₂O₃ content is less than 3 mol%, glass may be unstable. On the other hand, if the Al₂O₃ content exceeds 8 mol%, the glass melting temperature or the glass transition point (Tg) may excessively be high. The Al₂O₃ content is preferably at least 4 mol%, more preferably at least 5 mol%. Further, the Al₂O₃ content is preferably at most 7 mol%, more preferably at most 6 mol%.

CaO is added to increase the stability of glass and the precipitation property of crystals and to lower the glass melting temperature or the glass transition point (Tg). If the CaO content is less than 9 mol%, the glass melting temperature may excessively be high. On the other hand, if the CaO content exceeds 23 mol%, glass may be unstable. The CaO content is preferably at least 12 mol%, more preferably at least 13 mol%, particularly preferably at least 14 mol%. Further, the CaO content is preferably at most 22 mol%, more preferably at most 21 mol%, particularly preferably at most 20 mol%.

K₂O or Na₂O is added to lower the glass transition point (Tg). If the K₂O or Na₂O content or the total content of K₂O and Na₂O is less than 0.5 mol%, the glass melting temperature or the glass transition point (Tg) may excessively be high. On the other hand, if the K₂O or Na₂O content or the total content of K₂O and Na₂O exceeds 6 mol%, the chemical durability, particularly the acid resistance, may be deteriorated, and the electrical insulation property may also be deteriorated. The K₂O or Na₂O content or the total content of K₂O and Na₂O is preferably at least 0.8 mol% and at most 5 mol%.

The glass powder for substrate main body is not necessarily limited to one comprising only the above-described components and may contain other components within a range to satisfy various properties such as the glass transition point (Tg). When it contains such other components, their total content is preferably at most 10 mol%.

The glass powder for substrate main body is obtained by blending and mixing glass materials to achieve glass having the above composition and carrying out a melting method to produce glass, and grinding the obtained glass by a dry grinding method or a wet grinding method. In the case of a wet grinding method, it is preferred to employ water as a solvent. The grinding can be carried out by using a grinding machine such as a roll mill, a ball mill or a jet mill.

The 50% particle size (D₅₀) of the glass powder for substrate main body is preferably at least 0.5 µm and at most 2 µm. If the 50% particle size of the glass powder for substrate main body is less than 0.5 µm, the glass powder is likely to cohere, whereby the handling tends to be difficult, and it tends to be difficult to uniformly disperse it. On the other hand, if the 50% particle size of the glass powder for substrate main body exceeds 2 µm, the glass softening temperature is likely to rise, or the sintering is likely to be inadequate. The particle size can be adjusted, for example, by classification after the grinding as the case requires. In this specification, the particle size of a powder is a value measured by a particle size analyzer (manufactured by NIKKISO CO., LTD., tradename: MT3100II) of a laser diffraction scattering method.

On the other hand, as the ceramic filler, one used for the production of a LTCC substrate heretofore, having a melting point of at least 1,500°C, may be used without any particular restriction, and for example, an alumina powder, a zirconia powder or a mixture of an alumina powder and a zirconia powder is preferably employed. The 50% particle size (D₅₀) of the ceramic filler is preferably, for example, at least 0.5 µm and at most 4 µm. In addition to the above, there is a white ceramic filler, but its use is preferably avoided since it may cause drawbacks on a support for mounting a light-emitting element. Such drawbacks may, for example, be a decrease in the light reflectance, a decrease in the strength, a decrease in the sintering property, and an increase in the difference in the thermal expansion coefficient with a mounting substrate (for example, a glass epoxy substrate) due to a decrease in the thermal expansion coefficient.

The above glass powder for substrate main body and the ceramic filler are blended and mixed, for example, so that the glass powder for substrate main body would be at least 30 mass% and at most 50 mass%, and the ceramic filler would be at least 50 mass% and at most 70 mass%, to obtain a glass ceramic composition. To this glass ceramic composition, a binder and as the case requires, a plasticizer, a dispersing agent, a solvent, etc. are added to obtain a slurry.

As the binder, for example, polyvinyl butyral or an acrylic resin may be suitably used. As the plasticizer, for example, dibutyl phthalate, dioctyl phthalate or butyl benzyl phthalate may be employed. Further, as the solvent, an organic solvent such as toluene, xylene, 2-propanol or 2-butanol may suitably be employed.

The slurry thus obtained is formed into a sheet-form by e.g. a doctor blade method, followed by drying to obtain a green sheet 2a for main body.

Then, an electrical wiring conductor paste layer 3 is formed on one main surface of the green sheet 2a for main body thus obtained (step (A)), and further, a conductor paste layer 4 for external electrode terminal and a paste layer 6 for through hole conductor are formed on the other main surface to form a main body forming member 2A, the cross-section of which is shown in Fig. 4(A).

As a method for forming the electrical wiring conductor paste layer 3, the conductor paste layer 4 for external electrode terminal and the paste layer 6 for through hole conductor, a method of applying a conductor paste by a screen printing method or a method of applying and filling it may be mentioned. As the conductor paste, it is possible to use one having a vehicle such as ethyl cellulose, and as the case requires, a solvent etc. added to a metal powder comprising e.g. copper, silver or gold as the main component to form a paste. Further, as the above metal powder, a metal powder comprising silver, a metal powder comprising silver and platinum, or a metal powder comprising silver and palladium may preferably be employed.

Further, although not shown, the green sheet 2a for main body may have non-fired thermal vias, and in such a case, formation of the non-fired thermal vias is conducted in a step for preparing the main body forming member including the step (A) in the production process of the present invention.

### (B) Green sheet laminate preparation step

Fig. 4(B) is a view illustrating a cross-section before lamination of the main body forming member 2A obtained in the above step (A) and a green sheet 2b for covering to be laminated in the step (B).

The green sheet 2b for covering is made of a glass ceramic composition containing a glass powder and a ceramic filler, and has through holes 5' penetrating in a thickness direction at portions corresponding to electrical wiring conductors of the substrate for mounting a light-emitting element to be obtained. The green sheet 2b for covering finally becomes a member constituting the mounting surface of the substrate for mounting a light-emitting element of the present invention. Each of the through holes 5' becomes a concave on the mounting surface after the green sheet 2b for covering and the main body forming member 2A are laminated.

The green sheet 2b for covering is prepared by forming the above through holes 5' on a green sheet produced by using the same material components as for the above green sheet 2a for main body in the same production method.

Here, the depth of the concave on the mounting surface is determined by the thickness of the green sheet 2b for covering to be prepared. The thickness of the green sheet 2b for covering is adjusted so that the depth (h) of the concave after lamination and firing will be from 50 to 200 µm which is the above-mentioned preferred value.

Formation of the through holes 5' may be carried out, for example, by the same method as a conventional method of forming through holes on a green sheet, such as punching, without any particular restriction. The through holes 5' which the green sheet 2b for covering has are preferably formed such that their size is smaller than the size of the electrical wiring conductor paste layer 3 which the main body forming member 2A has on its main surface. The size of the through holes 5' is specifically preferably such that when the main body forming member 2A and the green sheet 2b for covering are laminated, the overlap width of the electrical wiring conductor paste layer 3 and the green sheet 2b for covering is from 50 to 150 µm.

The green sheet 2b for covering is overlaid on the main surface of the main body forming member 2A so as to face the electrical wiring conductor paste layer 3 through the through holes 5', and they are bonded by thermal compression to form a green sheet laminate 2.

### (C) Step of forming a paste layer for reflection film, etc.

Fig. 4(C) is a view illustrating a cross-section of a non-sintered substrate 1 for mounting a light-emitting element obtained by forming a paste layer 7 for reflection film and an overcoat glass paste layer 8 in this order by the step (C) on the surface of the green sheet 2b for covering of the green sheet laminate 2 obtained in the above step (B).

In the step (C), a paste layer 7 for reflection film to be a reflection film is formed by screen printing on the surface of the green sheet 2b for covering of the green sheet laminate 2 so as to exclude the concaves 5 formed by the through holes 5' and the vicinity of their periphery. The paste for reflection film to be used for screen printing may be the same paste as the above conductor paste, for example, one having a vehicle such as ethyl cellulose and as the case requires, a solvent, etc. added to a metal powder containing e.g. copper, silver or gold as the main component to form a paste. The metal material for the conductor paste may, for example, be specifically silver, a mixture of silver with palladium, a silver/palladium alloy, a mixture of silver with platinum, or a silver/platinum alloy, and a silver paste containing at least 95 mass% of silver is preferably used, which has a high reflectance. The silver paste may contain at most 5 mass% of glass frit to improve the adhesion strength. In one preferred embodiment of the present invention, the reflection film substantially comprising silver means a reflection film containing at least 90 mass% of silver, and a reflection film comprising a silver alloy is included. For example, palladium may be contained up to 10 mass%, and platinum may be contained up to 3 mass%.

The thickness of the paste layer 7 for reflection film to be formed is adjusted so that the reflection film to be finally obtained has the above desired thickness.

Further, the range of screen printing of the overcoat glass paste layer 8 on the paste layer 7 for reflection film is adjusted considering the screen printing position of the overcoat glass paste layer 8 so that the distance between the edge of the reflection layer 7 and the edge of the overcoat glass film 8 covering the reflection layer 7 in the substrate for mounting a light-emitting element to be finally obtained, is within the above desired range, i.e. preferably from 10 to 50 µm, more preferably from 20 to 30 µm.

After the above paste layer 7 for reflection film is formed, an overcoat glass paste layer 8 to be an overcoat glass film is formed by screen printing on the surface of the green sheet 2b for covering of the green sheet laminate 2 so as to cover the entire paste layer 7 for reflection film including its edge and so as to exclude the concaves 5 formed by the through holes 5' and the vicinity of their periphery, to obtain a non-sintered substrate 1 for mounting a light-emitting element.

The method of forming the overcoat glass paste layer 8 by screen printing is not particularly limited, but it is preferred to carry out printing so that the width (w) of a non-coated portion in the vicinity of the periphery of the concaves 5 in the substrate for mounting a light-emitting element to be finally obtained is from 20 to 80 µm which is the above-mentioned preferred width. The thickness of the overcoat glass paste layer 8 to be formed is adjusted so that the thickness of the overcoat glass film to be finally obtained would be the above-mentioned desired thickness.

The overcoat glass paste may be one having a vehicle such as ethyl cellulose and as the case requires, a solvent, etc. added to a glass powder (a glass powder for glass film) to form a paste.

The glass powder for glass film may be one whereby film-form glass is obtainable by firing simultaneously with the main body forming member 2A and the green sheet 2b for covering, and its 50% particle size (D₅₀) is preferably at least 0.5 µm and at most 2 µm. Further, the surface roughness Ra of the overcoat glass film 8 may be adjusted, for example, by the particle size of the glass powder for glass film. That is, by using, as the glass powder for glass film, one which can be sufficiently melted during firing and is excellent in fluidity, it is possible to reduce the surface roughness Ra.

### (D) Firing step

After the above step (C), binder burn out to remove the binder, etc., is carried out as the case requires and then, firing is carried out to sinter the glass ceramic composition, etc. to obtain a substrate 1 for mounting a light-emitting element.

The binder burn out is carried out preferably by holding the substrate, for example, at a temperature of at least 500°C and at most 600°C for at least one hour and at most 10 hours. If the binder burn out temperature is lower than 500°C or the binder burn out time is less than one hour, the binder, etc. may not sufficiently be removed. When the binder burn out temperature is about 600°C and the binder burn out time is about 10 hours, the binder, etc. can sufficiently be removed. On the other hand, if the binder burn out temperature exceeds 600°C, the productivity, etc. may rather be deteriorated.

Further, the firing is carried out by suitably adjusting the time within a temperature range of from 800°C to 930°C in consideration of the productivity of the substrate main body and securing a dense structure of the substrate main body. Specifically, it is preferred to hold the substrate at a temperature of at least 850°C and at most 900°C for at least 20 minutes and at most 60 minutes, particularly preferably at a temperature of at least 860°C and at most 880°C. If the firing temperature is lower than 800°C, one having a dense structure of the substrate main body may not be obtainable. On the other hand, if the firing temperature exceeds 930°C, the productivity etc. may deteriorate, for such a reason that the substrate main body undergoes deformation. Further, in a case where a metal paste containing a metal powder containing silver as the main component is used as the above conductor paste or paste for reflection film, if the firing temperature exceeds 880°C, softening proceeds excessively, and a prescribed shape may not be maintained.

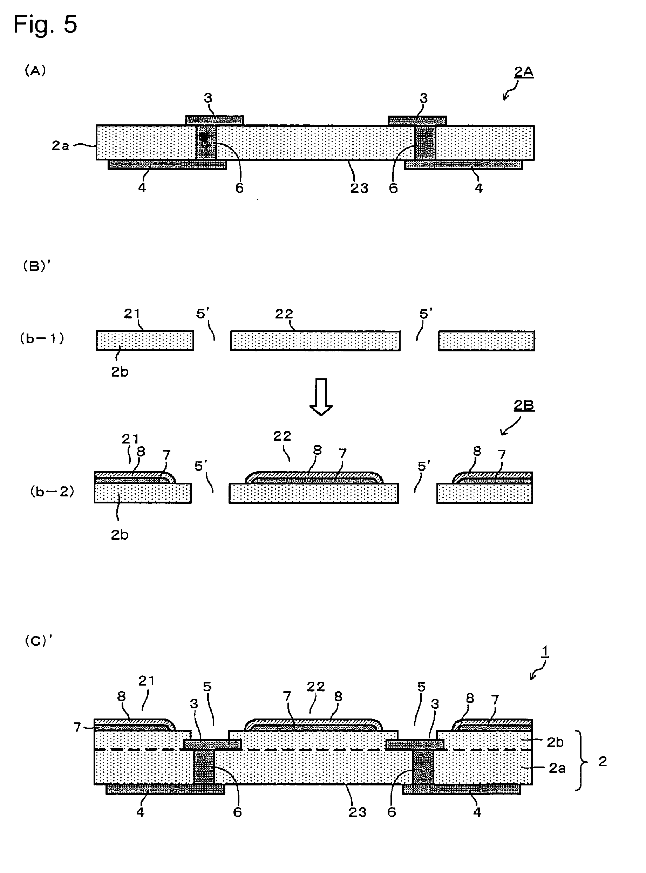

The production process according to the second embodiment of the present invention is specifically a process for producing the substrate for mounting a light-emitting element comprising the following steps (A), (B)', (C)' and (D), and one example of this embodiment will be described with reference to Fig. 5. More specifically, it is preferred to produce the substrate for mounting a light-emitting element of the present invention by carrying out the following respective steps (A) to (D) in this order.

Now, the respective steps (A) to (D) will be described in detail with reference to drawings.
(A) A step of preparing a green sheet for main body constituting mainly the substrate main body of the substrate for mounting a light-emitting element by using a glass ceramic composition containing a glass powder and a ceramic filler, and arranging an electrical wiring conductor paste layer by screen printing on predetermined positions on the main surface of the green sheet for main body to obtain a main body forming member (the same as the step (A) of the above first embodiment, hereinafter referred to as "a main body forming member preparation step").
(B)' A step of preparing a green sheet for covering constituting the mounting surface of the substrate for mounting a light-emitting element, made of the above glass ceramic composition and having through holes penetrating in a thickness direction at portions corresponding to the electrical wiring conductors of the substrate for mounting a light-emitting element, forming a paste layer for reflection film by screen printing on the surface to be the mounting surface of the obtained green sheet for covering so as to exclude the through holes and the vicinity of their periphery, and further forming an overcoat glass paste layer by screen printing so as to cover the entire paste layer for reflection film including its edge and so as to exclude the through holes and the vicinity of their periphery, to obtain a member for covering (hereinafter referred to as "a covering member preparation step").
(C)' A step of laminating the member for covering on the main surface of the main body forming member so as to face the electrical wiring conductor paste layer through the through holes and so that the overcoat glass paste layer faces upward, to obtain a non-sintered substrate for mounting a light-emitting element (hereinafter referred to as "a member lamination step").
(D) A step of firing the non-sintered substrate for mounting a light-emitting element at from 800 to 930°C (the same as the step (D) of the above first embodiment, hereinafter referred to as "a firing step").

Here, the production process according to the second embodiment is a production process comprising the same steps as in the production process according to the above first embodiment except that the paste layer 7 for reflection film and the overcoat glass paste layer 8 are formed on the surface to be the above mounting surface of the green sheet 2b for covering having the through holes 5' in the step (B)', and then the member for covering is laminated on the main body forming member in the step (C)', instead of carrying out the step (B) to prepare the green sheet laminate and then carrying out the step (C) to form the paste layer for reflection film and the overcoat glass paste layer on the surface of the green sheet for covering. That is, in the production process according to the second embodiment, the main body forming member preparation step (A) and the firing step (D) are entirely the same as in the production process according to the first embodiment.

### (A) Main body forming member preparation step

Fig. 5(A) is a view illustrating a cross-section of the main body forming member 2A obtained by the step including the above step (A), and is the same drawing as the above Fig. 4(A). The main body forming member 2A is prepared by the same method as the above method described in the first embodiment.

### (B)' Covering member preparation step

Fig. 5(B)' is to schematically illustrate a step of preparing a member 2B for covering which is a member to finally constitute the mounting surface of the substrate for mounting a light-emitting element of the present invention, the cross-section of which is shown in (b-2). (b-1) is a view illustrating a cross-section of a green sheet 2b for covering constituting the mounting surface of the substrate for mounting a light-emitting element, having through holes 5' penetrating in a thickness direction at portions corresponding to electrical wiring conductors of the substrate for mounting a light-emitting element. A paste layer 7 for reflection film is formed by screen printing on the surface to be the light-emitting element mounting surface of the green sheet 2b for covering shown in Fig. (b-1) so as to exclude the above through holes 5' and the vicinity of their periphery, and an overcoat glass paste layer 8 is further formed by screen printing so as to cover the entire paste layer 7 for reflection film including its edge and so as to exclude the above through holes 5' and the vicinity of their periphery, to obtain a member 2B for covering shown in (b-2).

The green sheet 2b for covering having the through holes 5' penetrating in a thickness direction at portions corresponding to electrical wiring conductors of the substrate for mounting a light-emitting element shown in (b-1), can be prepared by the same method as described in the step (B) of the above first embodiment.

Further, with respect to the member 2B for covering shown in (b-2), the method of forming the paste layer 7 for reflection film by screen printing on the surface to be the mounting surface of the green sheet 2b for covering having the through holes 5' so as to exclude the through holes 5' and the vicinity of their periphery, and further forming the overcoat glass paste layer 8 by screen printing so as to cover the entire paste layer 7 for reflection film including its edge and so as to exclude the through holes 5' and the vicinity of their periphery, may be carried out by the same method as the method described in the step (C) of the first embodiment.

### (C)' Member lamination step

Then, the member 2B for covering obtained in the above step (B) is overlaid on the main surface of the main body forming member 2A obtained in the above step (A) so as to face the electrical wiring conductor paste layer 3 through the through holes 5' and so that the overcoat glass paste layer 8 faces upward, that is, it becomes the uppermost layer, and they are bonded by thermal compression to prepare a non-sintered substrate 1 for mounting a light-emitting element, the cross-section of which is shown in Fig. 5(C)'.

The non-sintered substrate 1 for mounting a light-emitting element obtainable in such a manner has the same constitution as the non-sintered substrate 1 for mounting a light-emitting element, the cross-section of which is shown in Fig. 4(C) as described in the production process according to the first embodiment.

### (D) Firing step

Firing of the non-sintered substrate 1 for mounting a light-emitting element obtained in the above step (C)' may be carried out by the same method as described in the first embodiment.

The process for producing the substrate 1 for mounting a light-emitting element is described above, however, the green sheet 2a for main body and the green sheet 2b for covering are not necessarily be a single green sheet and may be a laminate of a plurality of green sheets. Further, the order of forming the respective members, etc. may suitably be changed so long as the substrate 1 for mounting a light-emitting element can be produced.

### EXAMPLES

Now, the present invention will be described in detail with reference to Examples. However, it should be understood that the present invention is by no means restricted thereto.

### [Example 1]

By the following method (the production process according to the second embodiment of the present invention), a test light-emitting device having the same constitution as the light-emitting device shown in Fig. 3 was prepared. In Example 1, a silver reflection film was used as the reflection film. Further, in the following description in Examples, in the same manner as above, regarding members to be used for production, layers to be formed, etc., symbols for the members, the layers, etc. are the same between before and after firing.

First, a green sheet 2a for main body and a green sheet 2b for covering to prepare a main body substrate of the substrate 1 for mounting a light-emitting element were prepared. As a glass powder to produce the green sheet 2a for main body and the green sheet 2b for covering, glass materials were blended and mixed to achieve a glass composition comprising, as represented by mol% as calculated as the following oxides, 60.4 mol% of SiO₂, 15.6 mol% of B₂O₃, 6 mol% of Al₂O₃, 15 mol% of CaO, 1 mol% of K₂O and 2 mol% of Na₂O, the material mixture was put in a platinum crucible and melted at 1,600°C for 60 minutes, and glass in a molten state was cast and cooled. The obtained glass was ground by an alumina ball mill for 40 hours to produce a glass powder for substrate main body. As a solvent at the time of grinding, ethyl alcohol was used.

40 mass% of the glass powder for substrate main body and 60 mass% of an alumina filler (manufactured by Showa Denko K.K., tradename: AL-45H) were blended and mixed to produce a glass ceramic composition. With 50 g of this glass ceramic composition, 15 g of an organic solvent (a mixture of toluene, xylene, 2-propanol and 2-butanol with a mass ratio of 4:2:2:1), 2.5 g of a plasticizer (di-2-ethylhexyl phthalate), 5 g of polyvinyl butyral (manufactured by Denki Kagaku Kogyo Kabushiki Kaisha, tradename: PVK#3000K) as a binder and 0.5 g of a dispersing agent (manufactured by BYK Japan KK, tradename: BYK180) were blended and mixed to prepare a slurry.

This slurry was applied on a PET film by a doctor blade method and dried to produce a green sheet for main body having a thickness after firing of 0.15 mm and to produce a green sheet for covering having a thickness after firing of 0.10 mm.

Further, an electrically conductive powder (silver powder, manufactured by DAIKEN CHEMICAL CO., LTD., tradename: S550) and ethyl cellulose as a vehicle were blended in a mass ratio of 85:15, and dispersed in α-terpineol as a solvent so that the solid content became 85 mass%, and the dispersion was kneaded in a porcelain mortar for one hour and further dispersed three times by a triple roll to prepare a metal paste (a paste for conductor).

Through holes having a diameter of 0.3 mm were formed by a punch at portions corresponding to a paste layer 6 for through hole conductor on the green sheet 2a for main body, and filled with a metal paste by a screen printing method to form a paste layer 6 for through hole conductor and to form a conductor paste layer 4 for external electrode terminal and an electrical wiring conductor paste layer 3, whereby a main body forming member 2a was produced.

Further, on the green sheet 2b for covering, through holes 5' corresponding to concaves 5 after lamination were formed, a paste layer 7 for silver reflection film was formed by screen printing on the surface of the green sheet 2b for covering so as to exclude the through holes 5' and the vicinity of their periphery, and an overcoat glass paste layer 8 was further formed by screen printing so as to cover the entire paste layer 7 for silver reflection film including its edge and so as to exclude the through holes 5' and the vicinity of their periphery, to obtain a member 2B for covering.

The above paste for silver reflection film was prepared in such a manner that a silver powder (manufactured by DAIKEN CHEMICAL CO., LTD., tradename: S400-2) and ethyl cellulose as a vehicle were blended in a mass ratio of 90:10 and dispersed in α-terpineol as a solvent so that the solid content became 87 mass%, and the dispersion was kneaded in a porcelain mortar for one hour and further dispersed three times by a triple roll.

Further, the glass powder for glass film used for preparation of the overcoat glass paste was produced as follows. First, glass materials were blended and mixed to achieve a glass composition comprising, as represented by mol% as calculated as the following oxides, 81.6 mol% of SiO₂, 16.6 mol% of B₂O₃ and 1.8 mol% of K₂O, this material mixture was put in a platinum crucible and melted at 1,600°C for 60 minutes, and glass in a molten state was cast and cooled. The obtained glass was ground by an alumina ball mill for from 8 to 60 hours to obtain a glass powder for glass film. 60 mass% of the glass powder for glass film and 40 mass% of a resin component (one containing ethyl cellulose and α-terpineol in a mass ratio of 85:15) were blended and kneaded in a porcelain mortar for one hour, and further dispersed three times by a triple roll to prepare an overcoat glass paste.

The above obtained member 2B for covering was overlaid on the main surface of the main body forming member 2A so as to face the electrical wiring conductor paste layer 3 through the through holes 5' and so that the overcoat glass paste layer 8 faced upward, that is, it became the outermost layer, and they were bonded by thermal compression to obtain a non-fired substrate 1 for mounting a light-emitting element, which was held at 550°C for 5 hours to carry out binder burn out and further held at 870°C for 30 minutes to carry out firing thereby to produce a substrate 1 for mounting a light-emitting element. In the obtained substrate 1 for mounting a light-emitting element, the width (represented by "w" in Fig. 3) of a non-coated portion of the substrate main body on the light-emitting element mounting surface was 50 µm by the average of optionally selected 10 points, and the difference (represented by "h" in Fig. 3) in the height between the light-emitting element mounting surface and the bottom of each concave 5 at which an electrical wiring conductor 3 was formed, was 100 µm.

A light-emitting diode element 11 was mounted on the substrate 1 for mounting a light-emitting element prepared in the above Example 1 to prepare a light-emitting device 10 as shown in Fig. 3. For preparation of this light-emitting device, one light-emitting diode element 11 (manufactured by Showa Denko K.K., tradename: GQ2CR460Z) was fixed on the mounting portion 22 by a die boding material (manufactured by Shin-Etsu Chemical Co., Ltd., tradename: KER-3000-M2) and further sealed to constitute a mold material 14 shown in Fig. 3 by using a sealing compound (manufactured by Shin-Etsu Chemical Co., Ltd., tradename: SCR-1016A). As the sealing compound, one comprising 20 mass% of a phosphor (manufactured by KASEI OPTONIX CO., LTD., tradename: P46-Y3) based on the sealing compound, was used.

The total flux with respect to the light-emitting device 10 according to the present invention thus obtained and the total flux with respect to a light-emitting device having a constitution corresponding to the following conventional light-emitting device, i.e. a light-emitting device employing a substrate for mounting a light-emitting element on which a silver reflection film and electrical wiring conductors were formed on the same plane, were measured by the following measuring method and compared, whereupon the light-emitting device according to the present invention had a flux improved by 5% as compared with the conventional light-emitting device.

### <Conventional light-emitting device>

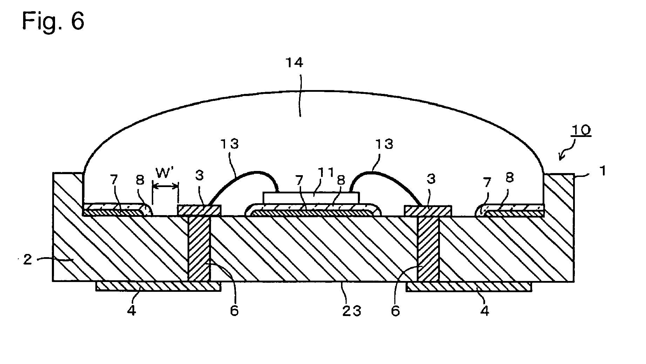

A test light-emitting device having a conventional constitution shown in Fig. 6 using the same substrate for mounting a light-emitting element as in Example 1 except that a structure such that the silver reflection film 7 was covered with the over glass film 8 including its edge and the electrical wiring conductors 3 were arranged on the same plane on the light-emitting element mounting surface was used, was prepared. With respect to the substrate for mounting a light-emitting element used, the width (represented by "w'" in Fig. 6) of a non-coated portion of the substrate main body on the light-emitting element mounting surface was 150 µm by the average of optionally selected 10 points.

Measurement of the total flux was carried out by a LED total flux measuring apparatus SOLID LAMBDA CCD LED MONITOR PLUS manufactured by Spectra Coop. The integrating sphere was 6 inch, and as a voltage/current generator, R6243 manufactured by ADVANTEST CORPORATION was used. Further, 35 mA was applied to the LED element for measurement.

### [Example 2]

A substrate 1 for mounting a light-emitting element was prepared in the same manner as in Example 1 except that using the same glass powder for substrate main body as in Example 1, 38 mass% of the glass powder for substrate main body, 38 mass% of an alumina filler (manufactured by Showa Denko K.K., tradename: AL-45H) and 24 mass% of a zirconia filler (manufactured by DAIICHI KIGENSO KAGAKU KOGYO CO., LTD., tradename: HSY-3F-J) were blended and mixed to produce a glass ceramic composition. A light-emitting diode element 11 was mounted on the substrate 1 for mounting a light-emitting element thus prepared to prepare a light-emitting device 10 as shown in Fig. 3 in the same manner as above.

The total flux with respect to the light-emitting device 10 obtained in Example 2 and the total flux with respect to the above conventional light-emitting device were compared, whereupon the light-emitting device according to the present invention had a flux improved by 5% as compared with the conventional light-emitting device.

### INDUSTRIAL APPLICABILITY

According to the present invention, it is possible to obtain a substrate for mounting a light-emitting element with a small area of a gap provided to achieve insulation between a metal reflection film and an electrical wiring conductor portion formed on the substrate, and which is excellent in the light extraction efficiency when a light-emitting element is mounted to form a light-emitting device.

Further, according to the light-emitting device using the substrate for mounting a light-emitting element of the present invention, as the gap area between the electrical wiring conductors and the reflection film of the substrate for mounting a light-emitting element is small, entrance of light emitted from the light-emitting element into the substrate main body can be suppressed, the light extraction efficiency can be made high, and light can be emitted with a high brightness. Such a light-emitting device may suitably be used, for example, as backlights for e.g. cellular phones or large-sized liquid crystal displays, illumination for automobiles or for decoration, or other light sources.

The entire disclosure of Japanese Patent Application No. 2010-017225 filed on January 28, 2010 including specification, claims, drawings and summary is incorporated herein by reference in its entirety.

### REFERENCE SYMBOLS

1: substrate for mounting a light-emitting element, 2: substrate main body, 3: electrical wiring conductor, 5: concave (stepped portion), 7: reflection film, 8: overcoat glass film, 9: non-coated portion on the substrate mounting surface, 10: light-emitting device, 11: light-emitting element, 21: mounting surface, 22: mounting portion, 23: non-mounting surface.

## Claims

1. A substrate for mounting a light-emitting element, which comprises a substrate main body made of a sintered product of a glass ceramic composition containing a glass powder and a ceramic filler, a part thereof constituting a mounting surface to be a mounting portion on which a light-emitting element is to be mounted;
electrical wiring conductors to be electrically connected to an electrode of the light-emitting element, arranged at a stepped portion differing in the height from the mounting surface provided on the mounting surface of the substrate main body;
a reflection film formed on the mounting surface excluding the stepped portion and the vicinity of its periphery; and
an overcoat glass film provided on the mounting surface so as to cover the entire reflection film including its edge and so as to exclude the stepped portion and the vicinity of its periphery.

2. The substrate for mounting a light-emitting element according to Claim 1, wherein the stepped portion forms a concave.

3. The substrate for mounting a light-emitting element according to Claim 1 or 2, wherein the width of a non-coated portion on the substrate mounting surface in the vicinity of the periphery of the stepped portion is from 20 to 80 µm.

4. The substrate for mounting a light-emitting element according to any one of Claims 1 to 3, wherein the difference in the height between the mounting surface and the stepped portion is from 50 to 200 µm.

5. The substrate for mounting a light-emitting element according to any one of Claims 1 to 4, wherein the reflection film substantially comprises silver.

6. A process for producing the substrate for mounting a light-emitting element as defined in any one of Claims 1 to 5, which comprises forming such a constitution that the substrate main body has the stepped portion differing in the height from the mounting surface on the mounting surface, by laminating a plurality of green sheets differing in the shape, made of a glass ceramic composition containing a glass powder and a ceramic filler, and forming the electrical wiring conductors, the reflection film and the overcoat glass film by screen printing.

7. A process for producing the substrate for mounting a light-emitting element as defined in any one of Claims 1 to 5, which comprises the following steps (A), (B), (C) and (D):
(A) a step of preparing a green sheet for main body constituting mainly the substrate main body of the substrate for mounting a light-emitting element by using a glass ceramic composition containing a glass powder and a ceramic filler, and arranging an electrical wiring conductor paste layer by screen printing on predetermined positions on the main surface of the green sheet for main body to obtain a main body forming member;
(B) a step of preparing a green sheet for covering constituting the mounting surface of the substrate for mounting a light-emitting element, made of the above glass ceramic composition and having through holes penetrating in a thickness direction at portions corresponding to the electrical wiring conductors of the substrate for mounting a light-emitting element, and laminating the green sheet for covering on the main surface of the main body forming member so as to face the electrical wiring conductor paste layer through the through holes to obtain a green sheet laminate;
(C) a step of forming a paste layer for reflection film by screen printing on the surface of the green sheet for covering of the green sheet laminate so as to exclude the through holes and the vicinity of their periphery, and further forming an overcoat glass paste layer by screen printing so as to cover the entire paste layer for reflection film including its edge and so as to exclude the through holes and the vicinity of their periphery to obtain a non-sintered substrate for mounting a light-emitting element; and
(D) a step of firing the non-sintered substrate for mounting a light-emitting element at from 800 to 930°C.

8. A process for producing the substrate for mounting a light-emitting element as defined in any one of Claims 1 to 5, which comprises the following steps (A), (B)', (C)' and (D):
(A) a step of preparing a green sheet for main body constituting mainly the substrate main body of the substrate for mounting a light-emitting element by using a glass ceramic composition containing a glass powder and a ceramic filler, and arranging an electrical wiring conductor paste layer by screen printing on predetermined positions on the main surface of the green sheet for main body to obtain a main body forming member;
(B)' a step of preparing a green sheet for covering constituting the mounting surface of the substrate for mounting a light-emitting element, made of the above glass ceramic composition and having through holes penetrating in a thickness direction at portions corresponding to the electrical wiring conductors of the substrate for mounting a light-emitting element, forming a paste layer for reflection film by screen printing on the surface to be the mounting surface of the obtained green sheet for covering so as to exclude the through holes and the vicinity of their periphery, and further forming an overcoat glass paste layer by screen printing so as to cover the entire paste layer for reflection film including its edge and so as to exclude the through holes and the vicinity of their periphery, to obtain a member for covering;
(C)' a step of laminating the member for covering on the main surface of the main body forming member so as to face the electrical wiring conductor paste layer through the through holes and so that the overcoat glass paste layer faces upward, to obtain a non-sintered substrate for mounting a light-emitting element; and
(D) a step of firing the non-sintered substrate for mounting a light-emitting element at from 800 to 930°C.

9. A light-emitting device comprising the substrate for mounting a light-emitting element as defined in any one of Claims 1 to 5, and a light-emitting element mounted on the mounting portion of the substrate for mounting a light-emitting element.

10. The light-emitting device according to Claim 9, wherein each of a pair of electrodes which each electrical wiring conductor arranged at the stepped portion provided on the mounting surface of the substrate for mounting a light-emitting element has and which the light-emitting element mounted on the mounting portion of the substrate for mounting a light-emitting element has, and each electrical wiring conductor, are connected in one-on-one by wire bonding.
